# EUROPÄISCHE PATENTSCHRIFT

(11) **EP 2 567 604 B1**
(45) Veröffentlichungstag und Bekanntmachung des Hinweises auf die Patenterteilung: **09.05.2018**
(21) Anmeldenummer: 11709675.0
(22) Anmeldetag: 10.03.2011
(51) Int. Cl.: H05K 7/20

(54) **RACKGEHÄUSE ZUR AUFNAHME EINER MEHRZAHL VON EINSCHUBKOMPONENTEN**
RACK HOUSING FOR RECEIVING A PLURALITY OF INSERT COMPONENTS
BOÎTIER EN BAIE POUR LE LOGEMENT D'UNE PLURALITÉ DE COMPOSANTS EN TIROIR

(30) Priorität: 19.05.2010 DE 102010021019; 05.05.2010 DE 102010019483
(43) Veröffentlichungstag der Anmeldung: 13.03.2013
(73) Patentinhaber: Fujitsu Limited, Kawasaki-shi Kanagawa 211-8588 (JP)
(72) Erfinder: SCHRÄDER, Bernhard, 33129 Delbrück (DE); NGUYEN, Van Son, 48231 Warendorf (DE)
(74) Vertreter: Epping - Hermann - Fischer
(86) Internationale Anmeldenummer: PCT/EP2011/053610
(87) Internationale Veröffentlichungsnummer: WO 2011/138079

(56) Entgegenhaltungen:
- EP-A1- 1 727 021
- US-A- 5 890 959
- US-A1- 2005 168 945
- US-A1- 2008 310 103

## Beschreibung

Die Erfindung betrifft eine Anordnung und ein Rackgehäuse zur Aufnahme einer Mehrzahl von Einschubkomponenten. Insbesondere betrifft sie ein Rackgehäuse mit einer Mehrzahl von Einschubpositionen zur Aufnahme der Mehrzahl von Einschubkomponenten in einem an eine erste Gehäuseseite angrenzenden, ersten Bereich des Rackgehäuses.

Solche Rackgehäuse sind vielfach bekannt. Beispielsweise werden sie in der Telekommunikationsindustrie zur Aufnahme von Vermittlungsgeräten verwendet. In der Computerindustrie finden solche Rackgehäuse, insbesondere in der Form von 19"-Rackgehäusen, zur Aufnahme von Servercomputern Verwendung. Insbesondere in so genannten Serverfarmen, in denen eine Vielzahl von Servercomputern auf einen möglichst geringen Raum angeordnet werden soll, sind derartige Rackgehäuse von Vorteil, da sie eine kompakte Anordnung der Einschubkomponenten gestatten.

Ein Problem bei der relativ dichten Anordnung von Einschubkomponenten in einem gemeinsamen Rackgehäuse besteht in deren Kühlung. Elektrische und elektronische Einschubkomponenten erzeugen in ihrem Betrieb oft eine nicht unerhebliche Abwärme, die zur Sicherstellung der korrekten Funktion der Einschubkomponenten regelmäßig abgeführt werden muss.

Zu diesem Zweck ist es insbesondere bekannt, in den einzelnen Einschubkomponenten Lüfter und ähnliche Kühlvorrichtungen vorzusehen, die einzelne, Wärme erzeugende Bauteile der Einschubkomponenten mittels Luft oder einem ähnlichen Kühlmedium kühlen. Insbesondere in Rechenzentren ist es üblich, die von mehreren Einschubkomponenten erzeugte erwärmte Luft gemeinsam abzuführen. Um die Umgebungsbedingungen in solchen Rechenzentren auf einem für die dort beschäftigten Personen und auch die Einschubkomponenten erträglichen Maß zu halten, werden oftmals Klimaanlagen zur Kühlung der Raumluft in den Räumen installiert, in denen eine Vielzahl von Einschubkomponenten angeordnet sind.

Ein Problem bekannter Rackgehäuse besteht darin, die oftmals an vielen verschiedenen Stellen einzelner Einschubkomponenten sowie die durch mehrere Einschubkomponenten erzeugte Abwärme kontrolliert und möglichst effizient aus dem gemeinsamen Rackgehäuse abzuführen. Dabei sollen neben der Effizienz der Anordnung auch die Betriebssicherheit der einzelnen, in das Rackgehäuse aufgenommenen Einschubkomponenten sichergestellt werden.

Aus der US 2005/0168945 A1 ist ein Computersystem mit einem Computerrack bekannt, dass zur Aufnahme einer Mehrzahl von Computerchassis in einem Computerstapelbereich eingerichtet ist. Ein Kühlkanal saugt Luft von den Rückseiten der Computerchassis an und führt diese über einen gemeinsamen Abluftanschluss über einen oder mehrere Ablufteinheiten ab.

Aus der EP 1 727 021 A1 ist ein redundantes Belüftungssystem für eine fortgeschrittene Telekommunikations-Computer-Architektur mit einem Feld von N+1 austauschbaren Lüftern bekannt. Aus der US 2008/0310103 A1 ist eine Vorrichtung zur Vermeidung eines Zurückströmens von Luft bekannt.

Zur Lösung des oben genannten und anderer Probleme wird eine Anordnung mit den Merkmalen gemäß Patentanspruch 1 und ein Rackgehäuse zur Aufnahme einer Mehrzahl von Einschubkomponenten gemäß Anspruch 13 vorgeschlagen.

Das Rackgehäuse umfasst eine Mehrzahl von Einschubpositionen zur Aufnahme der Mehrzahl von Einschubkomponenten in einem an eine erste Gehäuseseite angrenzenden, ersten Bereich des Rackgehäuses sowie einen Unterdruckschacht in einem an den ersten Bereich angrenzenden, zweiten Bereich des Rackgehäuses, wobei zwischen dem Unterdruckschacht und den Einschubkomponenten erste Öffnungen vorgesehen sind, die die Abfuhr von durch die Einschubkomponenten erwärmte Luft in den Unterdruckschacht ermöglichen. Das Rackgehäuse umfasst wenigstens zwei zweite Öffnungen zum Absaugen der erwärmten Luft aus dem Unterdruckschacht und wenigstens zwei, in dem Unterdruckschacht angeordnete und den zwei zweiten Öffnungen zugeordnete Rückschlaganordnungen, die ein Eintreten von Luft durch die jeweils zugeordnete zweite Öffnung verhindern, wenn durch diese zweite Öffnung keine Luft abgesaugt wird.

Ein derartiges Rackgehäuse mit einem zentralen Unterdruckschacht zum Abtransport von durch die Mehrzahl von Einschubkomponenten erwärmter Luft ermöglicht ein zentrales Kühlluftmanagement für das Rackgehäuse. Durch das Vorsehen von zwei zweiten Öffnungen, denen jeweils eine Rückschlaganordnung zugeordnet ist, wird die Funktion des Unterdruckschachts auch beim Ausfallen einer einzelnen Vorrichtung zum Absaugen der Warmluft sichergestellt.

Dabei ist zwischen den wenigstens zwei Rückschlaganordnungen wenigstens eine, zumindest teilweise in dem Unterdruckschacht angeordnete Trennwand angeordnet, die die zweiten Öffnungen lufttechnisch voneinander trennt. Durch eine derartige Trennwand kann der Strömungswiderstand zwischen den zwei zweiten Öffnungen vergrößert werden, sodass es beim Ausfall einer Absaugvorrichtung für die erwärmte Luft nicht zu einer Kurzschlussströmung zwischen den zwei zweiten Öffnungen kommt.

Dabei ist das Rackgehäuse durch eine zwischen dem ersten und zweiten Bereich angeordnete Schottwand gekennzeichnet, wobei die ersten Öffnungen in der Schottwand angeordnet sind. Durch das Vorsehen einer solchen Schottwand mit Öffnungen kann der Luftwiderstand zwischen dem ersten Bereich mit der Mehrzahl von Einschubkomponenten und dem zweiten Bereich mit dem Unterdruckschacht gemäß den Anforderungen eingestellt werden.

In einer bevorzugten Ausgestaltung ist das Rackgehäuse dadurch gekennzeichnet, dass eine Dichte, Größe und/oder Anzahl von ersten Öffnungen der Schottwand von der Entfernung der Einschubposition zu den zweiten Öffnungen und/oder den Rückschlaganordnungen abhängt. Bei Einsatz einer solchen Schottwand kann auf das Vorsehen von Stellelemente zum Einstellen eines Strömungswiderstandes weitgehend verzichtet werden.

Bei der beanspruchten Anordnung ist auf dem Rackgehäuse eine Ablufteinheit mit wenigstens zwei, den zweiten Öffnungen zugeordnete Lüftereinheit zum Absaugen der erwärmten Luft angeordnet.

Durch eine solche Ablufteinheit kann ein Unterdruck in dem Unterdruckschacht hergestellt werden.

Gemäß einer vorteilhaften Ausgestaltung umfasst die Ablufteinheit einen Wärmetauscher zum Übertragen der thermischen Energie der erwärmten Luft an ein Kühlmedium. Wird die thermische Energie von der erwärmten Luft an ein anderes Kühlmedium übertragen, kann auf den Einsatz von Klimaanlagen im Bereich des Rackgehäuses weitgehend verzichtet werden.

In einer weiteren vorteilhaften Ausgestaltung sind die Lüftereinheiten als Axiallüfter oder Schraubenlüfter ausgestaltet und die Ablufteinheit ist im Bereich der Lüftereinheiten nach oben offen. Durch eine solche Ausgestaltung der Ablufteinheit wird der Luftwiderstand beim Abpumpen der erwärmten Luft aus dem Unterdruckschacht reduziert, sodass ein besonders effizienter Betrieb der Ablufteinheit möglich ist.

Gemäß einer weiteren vorteilhaften Ausgestaltung sind die wenigstens zwei Lüftereinheiten in wenigstens zwei getrennten Haltevorrichtungen angeordnet, die sich einzeln aus der Ablufteinheit entnehmen lassen. Eine derartige Anordnung erlaubt das einfache Wechseln der einzelnen Lüftereinheiten während des Betriebs der Ablufteinheit.

Gemäß einer weiteren vorteilhaften Ausgestaltung sind die Lüftereinheiten als im Betrieb herausnehmbare Hot-Plug-Komponenten ausgestaltet, wobei beim Entnehmen jeweils einer der Lüftereinheiten die zugeordnete zweite Öffnung des Rackgehäuses durch die zugeordnete Rückschlaganordnung automatisch verschlossen wird, sodass ein Absaugen der erwärmten Luft über die jeweils andere Lüftereinheit erfolgt. Ein derartiges Rackgehäuse erleichtert den Austausch von Lüftereinheiten und erlaubt zugleich, das Rackgehäuse mit den darin angeordneten Einschubkomponenten während des Austauschs einer Lüftereinheit weiter zu betreiben.

Gemäß einer weiteren vorteilhaften Ausgestaltung verschließen sich die Rückschlaganordnungen automatisch, wenn in dem Unterdruckschacht ein geringerer Luftdruck herrscht als im Bereich der zugehörigen zweiten Öffnung und öffnen sich automatisch, wenn in dem Unterdruckschacht ein höherer Luftdruck herrscht als im Bereich der zugehörigen zweiten Öffnung. Durch eine derartige Anordnung kann weitgehend auf eine gesonderte Ansteuerung der Rückschlaganordnungen verzichtet werden. Diese wird im genannten Fall durch die Druckdifferenz zwischen dem Unterdruckschacht und dem Bereich der zugehörigen zweiten Öffnungen bewirkt.

Weitere vorteilhafte Ausgestaltungen sind in den Unteransprüchen sowie der nachfolgenden Beschreibung von Ausführungsbeispielen erläutert.

Die Erfindung wird nachfolgend anhand von Ausführungsbeispielen unter Bezugnahme auf Figuren im Detail erläutert. In den Figuren zeigen:
- Figur 1: eine schematische Darstellung eines Rackgehäuses mit zugehöriger Ablufteinheit gemäß einem ersten Ausführungsbeispiel,
- Figur 2: eine schematische Darstellung einer Ablufteinheit gemäß einem zweiten Ausführungsbeispiel,
- Figur 3: ein Querschnitt durch das Rackgehäuse gemäß dem zweiten Ausführungsbeispiel,
- Figur 4: eine Aufsicht auf eine Schottwand gemäß dem zweiten Ausführungsbeispiel,
- Figur 5: eine Aufsicht auf zwei über einem Unterdruckschacht angeordnete Lüftereinheiten,
- Figur 6: eine perspektivische Ansicht einer Anordnung umfassend eine Trennwand sowie zwei Rückschlaganordnungen und
- Figur 7: ein Querschnitt durch ein Rackgehäuse gemäß einer dritten Ausgestaltung der Erfindung.

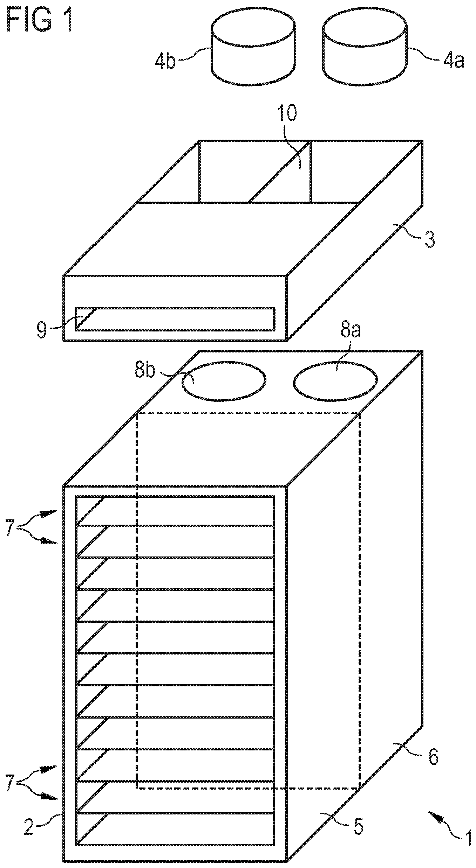

Figur 1 zeigt eine Explosionsdarstellung eines Rackgehäuses 1. Das Rackgehäuse 1 umfasst einen Gehäuseschrank 2, eine Ablufteinheit 3, sowie zwei Lüftereinheiten 4a und 4b.

Der Gehäuseschrank 2 ist in einen ersten Bereich 5 sowie einen zweiten Bereich 6 gegliedert. Im Ausführungsbeispiel befindet sich der erste Bereich 5 in einem vorderen Teil des Gehäuseschranks 2. Der zweite Bereich 6 befindet sich in einem daran anschließenden, hinteren Teil des Gehäuseschranks 2. Im Ausführungsbeispiel weist der erste Bereich 5 insgesamt elf Einschubpositionen 7 auf. In die Einschubpositionen 7 können Einschubkomponenten, die in der Figur 1 nicht dargestellt sind, von vorne in den Gehäuseschrank 2 eingeschoben werden.

Gemäß der Darstellung in der Figur 1 ist zwischen den einzelnen Einschubpositionen 7 jeweils ein Trennblech vorgesehen. Anstelle eines Trennblechs können die Einschubpositionen 7 aber auch lediglich durch Gehäusewandungen der aufgenommenen Einschubkomponenten voneinander getrennt sein. In diesem Falle ist es auch möglich, Einschubkomponenten unterschiedlicher Bauhöhen in den Gehäuseschrank 2 aufzunehmen. Beispielsweise ist es möglich, Einschubkomponenten aufzunehmen, die sich über mehrere, übereinanderliegende Einschubpositionen 7 erstrecken.

Im Ausführungsbeispiel ist der Gehäuseschrank 2 zu den Seiten sowie nach hinten und unten weitgehend luftdicht abgeschlossen. Auf einer oberen Gehäusefläche sind zwei Öffnungen 8 vorgesehen, die zum Abführen von erwärmter Luft aus dem Inneren des Gehäuseschranks 2 dienen. Insbesondere kann durch Absaugen von Warmluft durch die Öffnungen 8a und 8b in dem zweiten Bereich 6 des Gehäuseschranks 2 ein Unterdruck erzeugt werden. Besteht in dem zweiten Bereich 6 ein solcher Unterdruck, wird von in den Einschubpositionen 7 aufgenommenen Einschubkomponenten erzeugte Warmluft in den zweiten Bereich 6 des Gehäuseschranks 2 abgesogen. Hierfür ist es nicht erforderlich, dass in den einzelnen Einschubkomponenten Belüftungseinheiten vorgesehen sind. Solche Belüftungseinheiten können im Einzelfall optional dazu eingesetzt werden, den Durchfluss in einzelnen Bereichen der Einschubkomponenten zu vergrößern. Allerdings können solche zusätzlichen Lüfter zu Verwirbelungen führen und die Belüftung anderer Einschubkomponenten stören, so dass bevorzugt auf ihren Einsatz verzichtet werden sollte.

Im Ausführungsbeispiel wird der Unterdruck in dem zweiten Bereich 6 des Gehäuseschranks 2 durch die zwei Lüftereinheiten 4a und 4b, die in der Ablufteinheit 3 angeordnet sind, hergestellt beziehungsweise aufrechterhalten. Hierzu dient eine in der Figur 1 nicht dargestellte Steuereinheit, die beispielsweise in einem Einschubschacht 9 der Ablufteinheit 3 aufgenommen werden kann.

Im dargestellten Ausführungsbeispiel handelt es sich bei den Lüftereinheiten 4a und 4b beispielsweise um so genannte Schraubenlüfter, bei denen die aus dem Gehäuseschrank 2 abgesaugte Warmluft teilweise nach oben und teilweise zu den Seiten hin abgegeben wird. Um die Abgabe der erwärmten Luft so wenig wie möglich zu behindern, ist die Ablufteinheit 3 in einem hinteren Bereich, der in etwa der Projektion des zweiten Bereichs 6 des Gehäuseschranks 2 in die horizontale Ebene entspricht, nach oben offen. Die von den Lüftereinheiten 4a und 4b abgesaugte Warmluft kann daher weitgehend unbehindert nach oben abgeführt werden. Lediglich zwischen der ersten Lüftereinheit 4a und der zweiten Lüftereinheit 4b ist im Ausführungsbeispiel eine Trennwand 10 vorgesehen, um das Auftreten von Kurzschlussströmungen beim Ausfallen einer der Lüftereinheiten 4a beziehungsweise 4b zu verhindern.

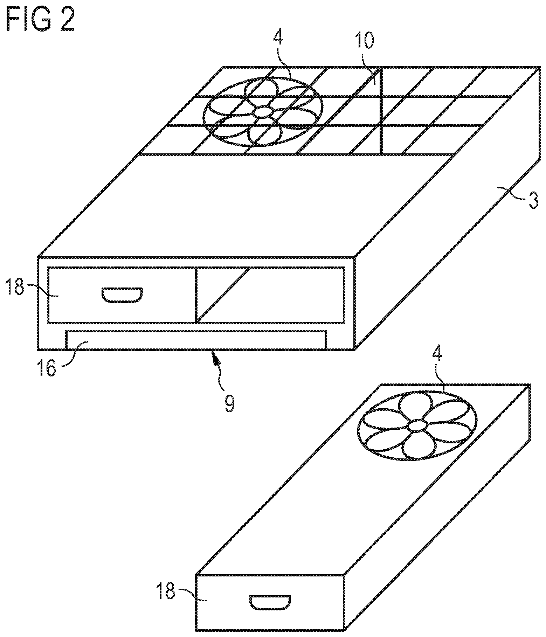

In der Figur 2 ist eine perspektivische Ansicht einer Ablufteinheit 3 gemäß einem zweiten Ausführungsbeispiel dargestellt.

Im dargestellten Ausführungsbeispiel ist ein Einschubschacht 9 für eine Steuereinrichtung 16ganz unten im Gehäuse der Ablufteinheit 3 angeordnet. Darüber befinden sich zwei voneinander getrennte Haltevorrichtungen zur Aufnahme von jeweils einer Lüftereinheit 4. Die Lüftereinheit 3 ist nach oben offen und weist im Bereich der Lüftereinheiten ein Schutzgitter 27 auf. Alternativ kann das Schutzgitter 27 auch direkt an den Lüftereinheiten 4 oder der Haltevorrichtung 18 angebracht sein oder vollständig weggelassen werden.

Die Haltevorrichtungen sind schubladenartig ausgestaltet, so dass die darin angeordneten Lüftereinheiten 4 einfach nach vorne aus der Ablufteinheit 3 herausgezogen werden können. Der elektrische Anschluss der Lüftereinheiten 4 ist so gestaltet, dass das Herausziehen und Ersetzen der Lüftereinheiten auch im Betrieb der Ablufteinheit 3 vorgenommen werden kann. Beispielsweise erkennt die Steuereinrichtung den Ausfall oder das Entfernen einer Lüftereinheit und regelt den verbleibenden Lüfter auf eine höhere Drehzahl. Nach Einsetzen bzw. Anschluss einer neuen Lüftereinheit wird die Drehzahl beider Lüfter zum Beispiel wieder auf eine niedrigere Drehzahl herabgesetzt.

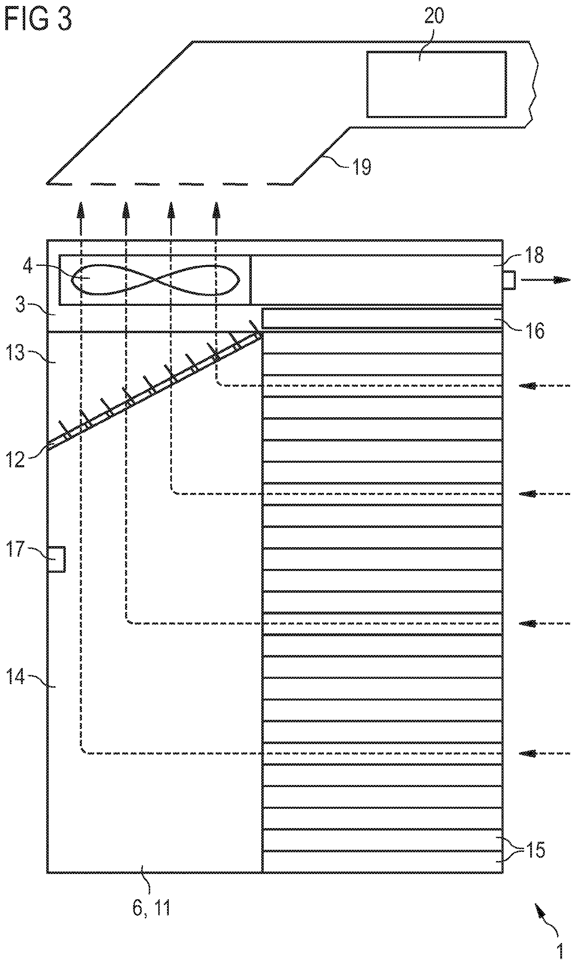

In der Figur 3 ist ein Querschnitt durch ein Rackgehäuse 1 gemäß dem zweiten Ausführungsbeispiel dargestellt. In dem Querschnitt der Figur 3 ist zu erkennen, dass in dem zweiten Bereich 6, der zugleich einen Unterdruckschacht 11 bildet, Rückschlaganordnungen 12 angeordnet sind. Im Ausführungsbeispiel handelt es sich bei den Rückschlaganordnungen 12 um ein Lamellengitter.

Wie in der Figur 3 dargestellt, ist das Lamellengitter schräg, also nicht in der horizontalen Ebene angeordnet. Dies weist unter anderem den Vorteil auf, dass der Öffnungswinkel der einzelnen Lamellen geringer ausfallen kann als bei horizontaler Anordnung. Auf diese Weise kann die zum Öffnen der Lamellen benötigte Kraft reduziert werden, ohne dass es zu einer Verringerung der Durchtrittsfläche kommt. Eine weitere Verringerung der benötigten Kraft kann durch ein Verschiebung der Drehachse der Lamellen, insbesondere die Anordnung der Drehachse in der Nähe des Schwerpunktes der Lamellen, bewirkt werden.

Ohne Einwirkung äußerer Kräfte fallen die in der Figur 3 dargestellten Lamellen des Lamellengitters in eine geschlossene Position zurück. Herrscht jedoch in einem Bereich 13 zwischen der Rückschlaganordnung 12 und einer Lüftereinheit 4 ein geringerer Luftdruck als in einem Bereich 14 unterhalb der Rückschlaganordnung 12, beispielsweise weil Luft durch die Lüftereinheit 4 nach oben abgesaugt wird, öffnen sich die Lamellen der Rückschlaganordnung 12. Auf diese Weise kann die von den Einschubkomponenten 15 erzeugte Warmluft über die Lüftereinheit 4 der Ablufteinheit 3 nach oben abgeführt werden.

Sowohl die Lüftereinheit 4 als auch die Rückschlaganordnung 12 ist in dem beschriebenen Rackgehäuse 1 wenigstens zwei Mal vorhanden, um eine Redundanz gegenüber dem Ausfall einer der Lüftereinheiten 4 sicherzustellen. Dies ist im Querschnitt der Figur 3 jedoch nicht zu erkennen, da die Lüftereinheiten 4 und die Rückschlaganordnungen 12 bezogen auf die dargestellte Schnittebene hinter einander angeordnet sind. Fällt eine der Lüftereinheiten 4, beispielsweise eine Lüftereinheit 4a aus, steigt der Luftdruck im oberen Bereich 13 zwischen der Lüftereinheit 4a und der Rückschlaganordnung 12 an und die Lamellen verschließen sich. In diesem Fall kann die durch die Einschubkomponenten 15 erzeugte Warmluft weiterhin durch eine anderer Lüftereinheit 4b durch die andere Rückschlaganordnung 12 abgesaugt werden, sodass in dem Unterdruckschacht 11 nach wie vor ein gegenüber dem Umgebungsluftdruck erniedrigter Luftdruck vorherrscht.

In einer bevorzugten Ausgestaltung umfasst das Rackgehäuse 1 hierzu eine Steuereinrichtung 16, die die Funktion und/oder die Drehzahl der Lüftereinheiten 4 überwacht. Zusätzlich oder alternativ kann auch ein oder mehrere Drucksensoren 17 im Bereich des Unterdruckschachts 11 vorgesehen sein, um den absoluten Druck in dem Unterdruckschacht 11 oder einen relativen Unterdruck bezogen auf einen Referenzsensor an der Außenseite des Rackgehäuses 1 zu ermitteln und die Lüftereinheiten 4 dementsprechend anzusteuern. Erkennt die Steuereinrichtung 16 beispielsweise ein Ansteigen des Luftdrucks in dem Unterdruckschacht 11, weil eine erste Lüftereinheit 4a ausgefallen ist, kann sie eine zweite Lüftereinheit 4b derart ansteuern, dass diese durch Erhöhung ihrer Drehzahl den Luftdruck im Bereich des Unterdruckschachts 11 wieder auf einen vorgegebenen Sollwert absenkt.

Alternativ ist es auch möglich, auf den Sensor 17 zu verzichten und stattdessen ein Tachosignal, wie es von vielen Lüftern bereitgestellt wird, an die Steuereinrichtung zurückzuliefern. In diesem Fall keine eine Überwachung der Lüftereinheiten 4 zusätzlich oder ausschließlich anhand des Tachosignals erfolgen.

Um eine Wartung beziehungsweise eine Reparatur der Lüftereinheiten 4 auch im laufenden Betrieb des Rackgehäuses 1 zu ermöglichen, sind die Lüftereinheit 4 wie unter Bezugnahme auf die Figur 2 beschrieben in schubladenartigen Haltevorrichtungen 18 angeordnet, die wie durch den Pfeil in der Figur 3 angedeutet nach vorne aus dem Rackgehäuse 1 herausgezogen werden können.

Im in der Figur 3 dargestellten Ausführungsbeispiel handelt es sich bei der Lüftereinheit 4 um einen so genannten Axiallüfter, der die von den Einschubkomponenten 15 erzeugte Warmluft in gerader Richtung aus dem Unterdruckschacht 11 nach oben absaugt. Zum Auffangen der erzeugten Warmluft ist in der Anordnung gemäß Figur 3 eine Ablufthaube 19 vorgesehen, die von der Ablufteinheit 3 ausgestoßene Abluft möglichst vollständig aufnimmt. Zur Rückgewinnung wenigstens eines Teils der in der Warmluft enthaltenen thermischen Energie ist in einem Abluftstutzen der Ablufthaube 19 ein Wärmetauscher 26 angeordnet, der mit einem Kühlmedium, beispielsweise Wasser, durchströmt wird. Auf diese Weise kann das durch die Einschubkomponenten 15 des Rackgehäuses 1 erzeugte Abwärme auf einfache und effiziente Weise zentral abgeführt werden. Selbstverständlich ist es auch möglich, den Wärmetauscher in die Ablufteinheit 3 zu integrieren. Im Zusammenhang mit intelligenten Heizkonzepten kann die abgeführte Abwärme an anderer Stelle eines umgebenden Gebäudes beispielsweise zur Heizung von Büroräumen verwendet werden.

Anstelle der Verwendung der Ablufteinheit 3 kann das Rackgehäuse 1 natürlich auch direkt an eine zentrale Gebäudeklimatisierung angeschlossen werden. Beispielsweise kann die Warmluft aus den Öffnungen 8 über Schläuche an einen oder mehrer Abluftkanäle einer Gebäudeinstallation angeschlossen werden.

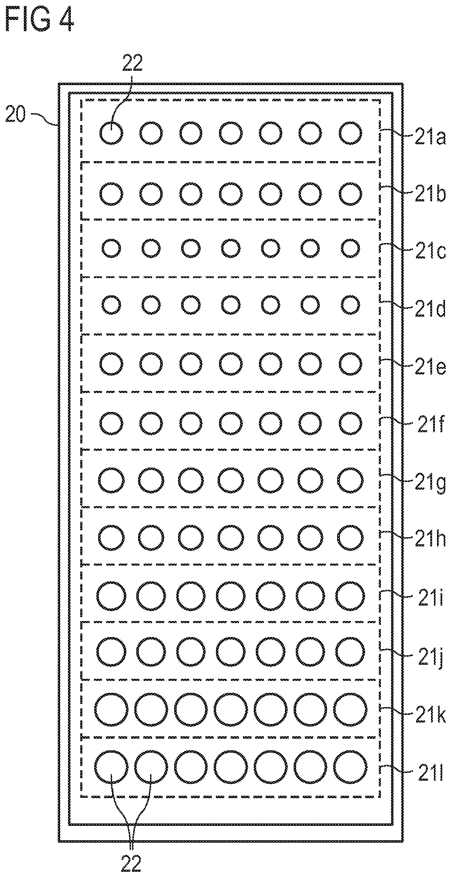

In der Figur 4 ist eine Schottwand 20 dargestellt, die in einem Ausführungsbeispiel den ersten Bereich 5 und den zweiten Bereich 6 des Gehäuseschranks 2 voneinander trennt. Die Schottwand 20 weist eine Anzahl von Abschnitten 21a bis 21j auf, die den Einschubpositionen 7 des Rackgehäuses 1 zugeordnet sind. In jedem Abschnitt 21 sind im Ausführungsbeispiel mehrere erste Öffnungen 22 angeordnet. Der Durchmesser der ersten Öffnungen 22 variiert dabei in Abhängigkeit der Position der Abschnitte 21.

Insbesondere nimmt der Durchmesser der Öffnungen 22 im Allgemeinen von oben nach unten zu. Auf diese Weise ist sichergestellt, dass die Luftdurchtrittsfläche im unteren Bereich des Rackgehäuses 1 größer ist als im oberen Bereich, der näher an der Ablufteinheit 3 gelegen ist. Abweichend von diesem allgemeinen Trend sind im Ausführungsbeispiel in den ganz oben gelegenen Abschnitten 21a und 21b wiederum größere Öffnungen 22 vorgesehen, um die partielle Abdeckung der oberen Einschubpositionen 7 durch die Rückschlaganordnung 12 beziehungsweise die durch die Rückschlaganordnung 12 verursachte Verwirbelung und damit einhergehende Vergrößerung des Luftwiderstands auszugleichen.

Anstelle der Größe der Öffnungen 22 kann natürlich auch dessen Anzahl bzw. Dichte in Abhängigkeit der Einschubposition 7 verändert werden, um den Luftwiderstand einzustellen. Auch eine aktive Regelung mit verstellbaren Öffnungen ist möglich. In einer alternativen Ausgestaltung sind die Öffnungen 22 in einer Rückseite der Einschubpositionen 7 bzw. in einer Rückwand der Einschubkomponenten 15 selbst vorgesehen. Die zusätzliche Schottwand 20 kann dann entfallen.

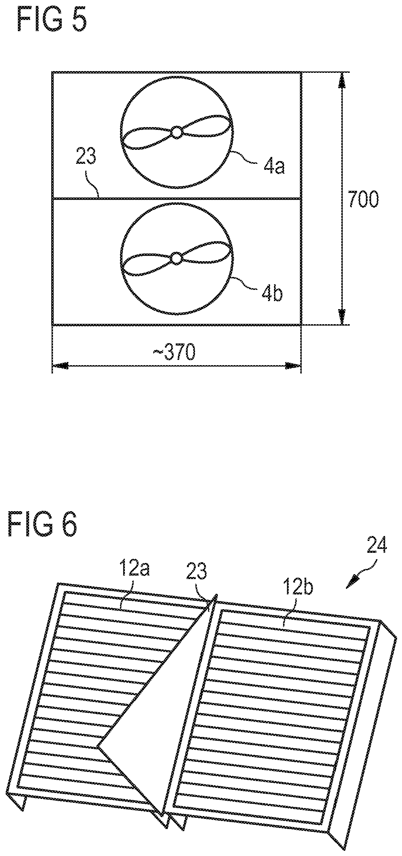

In der Figur 5 ist eine Aufsicht auf die zwei Lüftereinheiten 4a und 4b im Bereich des Unterdruckschachts 11 dargestellt. Darin ist ersichtlich, dass sich zwischen der ersten Lüftereinheit 4a und der zweiten Lüftereinheit 4b eine Trennwand 23 befindet. Die Trennwand 23 ist eine Fortsetzung der Trennwand 10 und ragt insbesondere in den Unterdruckschacht 11 hinein. Aus Gründen der einfacheren Montage des Rackgehäuses 1 sind die Trennwände 10 und 23 als getrennte, in der Ablufteinheit 3 bzw. dem Gehäuseschrank 2 angeordnete Bauteile ausgeführt.

Die Trennwand 23 ist ebenfalls in der perspektivischen Ansicht der Figur 6 eines Einsatzes 24 für den Unterdruckschacht 11 zu erkennen. Der in der Figur 6 dargestellte Einsatz 24 umfasst neben einer linken Rückschlaganordnung 12a und einer rechten Rückschlaganordnung 12b eine zwischen den beiden Rückschlaganordnungen 12a und 12b angeordnete Trennwand 23.

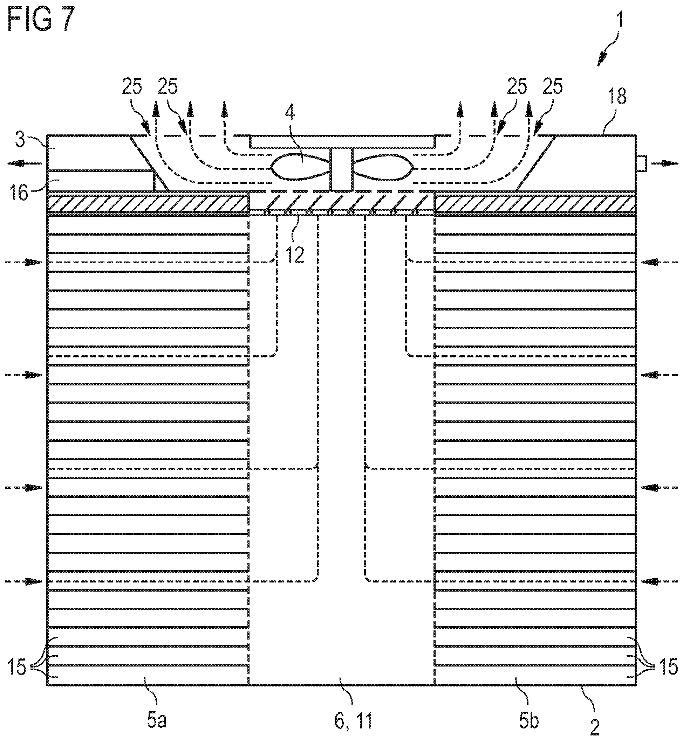

In der Figur 7 ist ein weiteres Ausführungsbeispiel eines erfindungsgemäßen Rackgehäuses 1 dargestellt.

Im Unterschied zu den Rackgehäusen gemäß den Figuren 1 bis 6 weist das Rackgehäuse 1 gemäß der Figur 7 drei Bereiche in einem Gehäuseschrank 2 auf. Das Rackgehäuse 1 umfasst gemäß Figur 7 zwei erste Bereiche 5a und 5b. Beispielsweise können in ein derartiges Rackgehäuse 1 von vorne und hinten oder von links und rechts Einschubkomponenten 15 in den Gehäuseschrank 2 eingeschoben werden. Zwischen den zwei Stapeln von Einschubkomponenten 15 liegt dabei ein Unterdruckschacht 11 in einem zweiten Bereich 6, über den die durch die Einschubkomponenten 15 erhitzte Luft zentral abgeführt wird.

Im Unterschied zu dem vorgehenden Ausführungsbeispiel sind die Rückschlaganordnungen 12 horizontal in den Unterdruckschacht 11 angeordnet. Des Weiteren werden als Lüftereinheiten 4 anstelle von Axial- oder Schraubenlüftern im Ausführungsbeispiel gemäß Figur 7 Radiallüfter eingesetzt. Die in der Figur 6 hintereinander liegenden Lüftereinheiten 4 pumpen die erwärmte Luft aus dem Unterdruckschacht 11 ab und befördern sie in horizontaler Richtung nach außen. Links und rechts neben der Lüftereinheit 4 ist ein entsprechender Freiraum vorgesehen, aus dem die Luft schließlich durch Lüftungsöffnungen 25 der Ablufteinheit 3 nach oben entweichen kann. Eine derartige, großräumige Ablufteinheit 3 eignet sich besonders zur Aufnahme weiterer Komponenten, beispielsweise eines Wärmetauschers.

Im dargestellten Ausführungsbeispiel kann die Lüftereinheit 4 der Ablufteinheit 3 nach rechts aus der Ablufteinheit 3 herausgezogen werden. Umgekehrt kann eine Steuereinrichtung 16 nach links aus dem Gehäuseschrank 2 beziehungsweise der Ablufteinheit 3 herausgezogen werden.

Die bezüglich der unterschiedlichen Ausführungsbeispiele beschriebenen Einzelmerkmale können in beinahe beliebiger Weise miteinander kombiniert werden. Beispielsweise kann auch die axiale Belüftungsanordnung, wie sie insbesondere bezüglich der Figuren 2 und 3 beschrieben wurde, mit einem doppelreihigen Rackgehäuse, wie es insbesondere in der Figur 7 dargestellt ist, kombiniert werden und umgekehrt.

Selbstverständlich können anstelle der zwei Lüftereinheiten 4 und zugehörigen Gehäuseöffnungen 8 und Rückschlaganordnungen 12 auch drei oder mehr Lüftereinheiten 4 beziehungsweise Öffnungen 8 und Rückschlaganordnungen vorgesehen werden, um die Kühlleistung weiter zu erhöhen beziehungsweise zusätzliche Redundanzen zu schaffen.

### Bezugszeichenliste

- 1: Gehäuse
- 2: Gehäuseschrank
- 3: Ablufteinheit
- 4: Lüftereinheit
- 5: erster Bereich
- 6: zweiter Bereich
- 7: Einschubposition
- 8: (zweite) Öffnung
- 9: Einschubschacht
- 10: Trennwand
- 11: Unterdruckschacht
- 12: Rückschlaganordnung
- 13: (oberer) Bereich
- 14: (unterer) Bereich
- 15: Einschubkomponente
- 16: Steuereinrichtung
- 17: Drucksensor
- 18: Haltevorrichtung
- 19: Ablufthaube
- 20: Schottwand
- 21: Abschnitt
- 22: (erste) Öffnung
- 23: Trennwand
- 24: Einsatz
- 25: Lüftungsöffnung
- 26: Wärmetauscher

## Patentansprüche

1. Anordnung, umfassend ein Rackgehäuse (1) zur Aufnahme einer Mehrzahl von Einschubkomponenten (15) und eine auf dem Rackgehäuse (1) angeordnete Ablufteinheit (3) mit wenigstens zwei Lüftereinheiten (4) zum Absaugen erwärmter Luft, wobei das Rackgehäuse Folgendes umfasst:
- eine Mehrzahl von Einschubpositionen (7) zur Aufnahme der Mehrzahl von Einschubkomponenten (15) in einem an eine erste Gehäuseseite angrenzenden, ersten Bereich (5) des Rackgehäuses (1),
- einen Unterdruckschacht (11) in einem an den ersten Bereich (5) angrenzenden, zweiten Bereich (6) des Rackgehäuses (1) und
- eine zwischen dem ersten Bereich (5) und dem zweiten Bereich (6) angeordnete Schottwand (20), wobei in der Schottwand (20) zwischen dem Unterdruckschacht (11) und den Einschubkomponenten (15) erste Öffnungen (22) angeordnte sind, die die Abfuhr von durch die Einschubkomponenten (15) erwärmte Luft in den Unterdruckschacht (11) ermöglichen,
**gekennzeichnet durch**
- wenigstens zwei zweite Öffnungen (8) des Rackgehäuses (1) zum Absaugen der erwärmten Luft aus dem Unterdruckschacht (11), die den wenigstens zwei Lüftereinheiten (4) der Ablufteinheit (3) zugeordnet sind, um den erniedrigten Luftdruck in dem Unterdruckschacht (11) herzustellen,
- wenigstens zwei, in dem Unterdruckschacht (11) angeordnete und den zwei zweiten Öffnungen (8) derart zugeordnete Rückschlaganordnungen (12), dass sie ein Eintreten von Luft durch die jeweils zugeordnete zweite Öffnung (8) verhindern, wenn durch diese zweite Öffnung (8) keine Luft abgesaugt wird,
- wenigstens eine zwischen den wenigstens zwei Rückschlaganordnungen (12) und zumindest teilweise in dem Unterdruckschacht (11) angeordnete Trennwand (23) zum Vergrößern eines Strömungswiderstands zwischen den zwei zweiten Öffnungen (8), die die zweiten Öffnungen (8) lufttechnisch voneinander trennt, sodass es beim Ausfall einer Absaugvorrichtung für die erwärmte Luft nicht zu einer Kurzschlussströmung zwischen den zwei zweiten Öffnungen kommt,
- wenigstens einen ersten Drucksensor (17) im Bereich des Unterdruckschachts (11) und
- eine mit dem wenigstens einen ersten Drucksensor (17) und den wenigstens zwei Lüftereinheiten (4) verbundene Steuereinrichtung (16) zum Ansteuern der Lüftereinheiten (4) in Abhängigkeit des durch den ersten Drucksensor (17) gemessenen Drucks in dem Unterdruckschacht (11).

2. Anordnung nach Anspruch 1,
**dadurch gekennzeichnet, dass**
die wenigstens zwei Rückschlaganordnungen (12) in einer bezogen auf eine Ebene der zweiten Öffnungen (8) schräg angeordneten Ebene in dem Unterdruckschacht (11) angeordnet sind.

3. Anordnung nach einem der Ansprüche 1 oder 2,
**dadurch gekennzeichnet, dass**
die Rückschlaganordnungen (12) als Rückschlagklappen oder Rückschlaglamellen ausgestaltet sind.

4. Anordnung nach einem der Ansprüche 1 bis 3,
**dadurch gekennzeichnet, dass**
eine Dichte, Größe und/oder Anzahl von ersten Öffnungen (22) in der Schottwand (20) in Abhängigkeit der Entfernung der Einschubposition (7) zu den zweiten Öffnungen (8) und/oder den Rückschlaganordnungen (12) zunimmt.

5. Anordnung nach einem der Ansprüche 1 bis 4,
**dadurch gekennzeichnet, dass**
die Ablufteinheit (3) einen Wärmetauscher (26) zum Übertragen der thermischen Energie der erwärmten Luft an ein Kühlmedium umfasst.

6. Anordnung nach einem der Ansprüche 1 bis 5,
**dadurch gekennzeichnet, dass**
die Lüftereinheiten (3) als Axiallüfter oder Schraubenlüfter ausgestaltet sind und die Ablufteinheit (3) im Bereich der Lüftereinheiten (4) nach oben offen ist.

7. Anordnung nach einem der Ansprüche 1 bis 6,
**dadurch gekennzeichnet, dass**
die wenigstens zwei Lüftereinheiten (4) in wenigstens zwei getrennten Haltevorrichtungen (18) angeordnet sind, die sich einzeln aus der Ablufteinheit (3) entnehmen lassen.

8. Anordnung nach einem der Ansprüche 1 bis 7,
**dadurch gekennzeichnet, dass**
die Lüftereinheiten (4) als im Betrieb herausnehmbare Hot-Plug-Komponenten ausgestaltet sind, wobei beim Entnehmen jeweils einer der Lüftereinheiten (4a) die zugeordnete zweite Öffnung (8a) durch die zugeordnete Rückschlaganordnung (12a) automatisch verschlossen wird, sodass ein Absaugen der erwärmten Luft über die jeweils andere Lüftereinheit (4b) erfolgt.

9. Anordnung nach einem der Ansprüche 1 bis 8,
**dadurch gekennzeichnet, dass**
die Steuereinrichtung (16) dazu eingerichtet ist, den durch den ersten Drucksensor (17) gemessenen Druck mit einem Sollwert zu vergleichen und wenigstens einen der wenigstens zwei Lüftereinheiten (4) zu deaktivieren, wenn nur eine Lüftereinheit (4) zum Einhalten des Sollwertes erforderlich ist.

10. Anordnung nach Anspruch 9,
**gekennzeichnet durch**
wenigstens zwei, den wenigstens zwei Rückschlaganordnungen (12) zugeordneten und mit der Steuereinrichtung (16) verbundenen Aktoren zum Öffnen und Schließen der Rückschlaganordnungen (12) durch die Steuereinrichtung (16).

11. Anordnung nach einem der Ansprüche 1 bis 10,
**dadurch gekennzeichnet, dass**
die Rückschlaganordnungen (12) sich automatisch verschließen, wenn in dem Unterdruckschacht (11) ein geringerer Luftdruck herrscht als im Bereich (13) der zugehörigen zweiten Öffnung (8), und sich automatisch öffnet, wenn in dem Unterdruckschacht (11) ein höherer Luftdruck herrscht als im Bereich (13) der zugehörigen zweiten Öffnung (8).

12. Anordnung nach einem der Ansprüche 1 bis 11,
**dadurch gekennzeichnet, dass**
die Ablufteinheit (3) zum Anschluss an ein Abluftsystem eines Gebäudes, insbesondere zum Anschluss an einen Ventilationsschacht, eingerichtet sind.

13. Rackgehäuse (1) zur Aufnahme einer Mehrzahl von Einschubkomponenten (15) zur Verwendung in einer Anordnung nach einem der Ansprüche 1 bis 12, umfassend:
- eine Mehrzahl von Einschubpositionen (7) zur Aufnahme der Mehrzahl von Einschubkomponenten (15) in einem an eine erste Gehäuseseite angrenzenden, ersten Bereich (5) des Rackgehäuses (1),
- einen Unterdruckschacht (11) in einem an den ersten Bereich (5) angrenzenden, zweiten Bereich (6) des Rackgehäuses (1) und
- eine zwischen dem ersten Bereich (5) und dem zweiten Bereich (6) angeordnete Schottwand (20), wobei in der Schottwand (20) zwischen dem Unterdruckschacht (11) und den Einschubkomponenten (15) erste Öffnungen (22) angeordnet sind, die die Abfuhr von durch die Einschubkomponenten (15) erwärmte Luft in den Unterdruckschacht (11) ermöglichen,
**gekennzeichnet durch**
- wenigstens zwei zweite Öffnungen (8) zum Absaugen der erwärmten Luft aus dem Unterdruckschacht (11), um den erniedrigten Luftdruck in dem Unterdruckschacht (11) herzustellen,
- wenigstens zwei, in dem Unterdruckschacht (11) angeordnete und den zwei zweiten Öffnungen (8) derart zugeordnete Rückschlaganordnungen (12), dass sie ein Eintreten von Luft durch die jeweils zugeordnete zweite Öffnung (8) verhindern, wenn durch diese zweite Öffnung (8) keine Luft abgesaugt wird, und
- wenigstens eine zwischen den wenigstens zwei Rückschlaganordnungen (12) und zumindest teilweise in dem Unterdruckschacht (11) angeordnete Trennwand (23) zum Vergrößern eines Strömungswiderstands zwischen den zwei zweiten Öffnungen (8), die die zweiten Öffnungen (8) lufttechnisch voneinander trennt, sodass es beim Ausfall einer Absaugvorrichtung für die erwärmte Luft nicht zu einer Kurzschlussströmung zwischen den zwei zweiten Öffnungen kommt, und
- wenigstens einen ersten Drucksensor (17) im Bereich des Unterdruckschachts (11) zum Messen eines Drucks in dem Unterdruckschacht (11).

## Claims

1. Arrangement, including a rack housing (1) for receiving a plurality of plugin components (15) and an exhaust air unit (3) arranged on the rack housing (1) with at least two fan units (4) for suctioning-off heated air, wherein the rack housing includes the following:
- a plurality of plugin positions (7) for receiving the plurality of plugin components (15) in a first region (5) bordering a first housing side of the rack housing (1),
- a negative-pressure duct (11) in a second region (6) of the rack housing (1) that borders the first region (5), and
- a partitioning wall (20) arranged between the first region (5) and the second region (6), wherein first openings (22) are arranged in the partitioning wall (20) between the negative-pressure duct (11) and the plugin components (15), which allow evacuating air heated by the plugin components (15) into the negative-pressure duct (11),
**characterized by**
- at least two second openings (8) of the rack housing (1) for suctioning-off the heated air from the negative-pressure duct (11), which are assigned to the at least two fan units (4) of the exhaust air unit (3), in order to generate the reduced air pressure in the negative-pressure duct (11),
- at least two non-return arrangements (12) arranged in the negative-pressure duct (11) and assigned to the two second openings (8) in such a way, that they prevent air from entering through the respectively assigned second opening (8), if no air is suctioned-off through this second opening (8),
- at least one partitioning wall (23) arranged between the at least two non-return arrangements (12) and at least in part in the negative-pressure duct (11) for increasing a flow resistance between the two second openings (8), which separates the second openings (8) from one another in an air-technical manner, so that no short-circuiting flow occurs between the two second openings upon a failure of an exhaust device for the heated air,
- at least one first pressure sensor (17) in the region of the negative-pressure duct (11) and
- at least one control means (16) connected to the at least one first pressure sensor (17) and the at least two fan units (4) for controlling the fan units (4) depending on the pressure in the negative-pressure duct (11) measured by the first pressure sensor (17).

2. The arrangement according to claim 1,
**characterized in that**
the at least two non-return arrangements (12) are arranged in the negative-pressure duct (11) in a plane arranged obliquely with respect to a plane of the second openings (8).

3. The arrangement according to one of claims 1 or 2,
**characterized in that**
the non-return arrangements (12) are firmed as non-return flaps or non-return lamellae.

4. The arrangement according to one of claims 1 to 3,
**characterized in that**
a density, size and/or number of first openings (22) in the partitioning wall (20) increases depending on the distance of the plugin position (7) to the second openings (8) and/or to the non-return arrangements (12).

5. The arrangement according to one of claims 1 to 4,
**characterized in that**
the exhaust air unit (3) includes a heat exchanger (26) for transferring the thermal energy of the heated air to a cooling medium.

6. The arrangement according to one of claims 1 to 5,
**characterized in that**
the fan units (3) are configured as axial fans or radial fans and the exhaust air unit (3) is open upwardly in the region of the fan units (4).

7. The arrangement according to one of claims 1 to 6,
**characterized in that**
the at least two fan units (4) are arranged in at least two separate holding units (18), which can be removed from the exhaust air unit (3) individually.

8. The arrangement according to one of claims 1 to 7,
**characterized in that**
the fan units (4) are configured as hot-plug components that can be removed during operation, wherein during removal of in each case one of the fan units (4a), the assigned second opening (8a) is automatically closed by the assigned non-return arrangement (12a), such that a suctioning-off of the heated air is effected via the respective other fan unit (4b).

9. The arrangement according to one of claims 1 to 8,
**characterized in that**
the control means (16) is configured to compare the pressure measured by the first pressure sensor (17) to a desired value, and to deactivate at least one of the at least two fan units (4), if only one fan unit (4) is required for meeting the desired value.

10. The arrangement according to claim 9,
**characterized by**
at least two actuators for opening and closing the non-return arrangements (12) by means of the control means (16) and assigned to the at least two non-return arrangements (12) and connected to the control means (16).

11. The arrangement according to one of claims 1 to 10,
**characterized in that**
the non-return arrangements (12) automatically block, if an air pressure lower than in the region (13) of the assigned second opening (8) prevails in the negative-pressure duct (11), and automatically open, if an air pressure higher than in the region (13) of the assigned second opening prevails in the negative pressure duct (11).

12. The arrangement according to one of claims 1 to 11,
**characterized in that**
the exhaust air unit (3) is configured for being connected to an exhaust air system of a building, in particular for being connected to a venting duct.

13. Rack housing (1) for receiving a plurality of plugin components (15) for use in an arrangement according to one of claims 1 to 12, including:
- a plurality of plugin positions (7) for receiving the plurality of plugin components (15) in a first region (5) of the rack housing (1) bordering a first housing side,
- a negative-pressure duct (11) in a second region (6) of the rack housing (1) bordering the first region (5), and
- a partitioning wall (20) arranged between the first region (5) and the second region (6), wherein first openings (22) are arranged in the partitioning wall (20) between the negative-pressure duct (11) and the plugin components (15), which allow evacuating air heated by the plugin components (15) into the negative-pressure duct (11),
**characterized by**
- at least two second openings (8) for suctioning-off the heated air from the negative-pressure duct (11), in order to generate the reduced air pressure in the negative-pressure duct (11),
- at least two non-return arrangements (12) arranged in the negative-pressure duct (11) and assigned to the two second openings (8) in such a way, that they prevent air from entering through the respective assigned second opening (8), if no air is suctioned-off through this second opening (8), and
- at least one least one partitioning wall (23) arranged between the at least two non-return arrangements (12) and at least in part in the negative-pressure duct (11) for increasing a flow resistance between the two second openings (8), which separates the second openings (8) from one another in an air-technical manner, so that no short-circuiting flow occurs between the two second openings upon a failure of an exhaust device for the heated air, and
- at least one first pressure sensor (17) in the region of the negative-pressure duct (11) for measuring a pressure in the negative-pressure duct (11).

## Revendications

1. Agencement comprenant un boîtier en baie (1) pour le logement d'une pluralité de composants en tiroir (15) et comprenant une unité d'aération d'air (3) disposée sur le boîtier en baie (1), prévue d'au moins deux unités de ventilateur (4) destinées à aspirer l'air échauffé, le boîtier en baie comprenant les éléments suivantes :
- une pluralité de positions en tiroir (7) pour le logement de la pluralité de composants en tiroir (15) dans une première zone (5) du boîtier en baie (1), adjacente à un premier côté de boîtier,
- un canal de dépression(11) dans une deuxième zone (6) du boîtier en baie (1), adjacente à la première zone (5), et
- une cloison (20) disposée entre la première zone (5) et la deuxième zone (6), des premières ouvertures (22) étant disposées dans la cloison (20) entre le canal de dépression(11) et les composants en tiroir (15), lesquelles permettent l'évacuation dans le canal de dépression(11) de l'air échauffé par les composants en tiroir (15),
**caractérisé par**
- au moins deux deuxièmes ouvertures (8) du boîtier en baie (1), destinées à évacuer l'air échauffé hors du canal de dépression(11), lesquelles sont associées aux au moins deux unités de ventilateur (4) de l'unité d'évacuation d'air (3) afin d'établir la pression d'air baissée dans le canal de dépression(11),
- au moins deux agencements d'anti-retour (12) disposés dans le canal de dépression(11) et associés aux deux deuxièmes ouvertures (8) de manière à ce qu'ils empêchent une entrée d'air à travers la deuxième ouverture (8) respectivement associée, lorsque de l'air n'est pas aspiré à travers cette deuxième ouverture (8),
- au moins une paroi de séparation (23) disposée entre les au moins deux agencements d'anti-retour (12) et au moins en partie dans le canal de dépression(11), destinée à augmenter une résistance d'écoulement entre les deux deuxièmes ouvertures (8), laquelle paroi de séparation sépare les unes des autres les deuxièmes ouvertures (8) du point de vue technique de l'écoulement d'air, de sorte qu'en cas de défaillance d'un dispositif d'aspiration de l'air échauffé, il n'y ait pas de courant de court-circuit entre les deux deuxièmes ouvertures,
- au moins un premier capteur de pression (17) dans la zone du canal de dépression(11) et
- un dispositif de commande (16) relié à l'au moins un premier capteur de pression (17) et aux au moins deux unités de ventilateur (4), destiné à commander les unités de ventilateur (4) en fonction de la pression mesurée par le premier capteur de pression (17) dans le canal de dépression (11).

2. Agencement selon la revendication 1,
**caractérisé en ce que**
les au moins deux agencements d'anti-retour (12) sont disposés dans le canal de dépression(11) dans un plan disposé de manière oblique par rapport à un plan des deuxièmes ouvertures (8).

3. Agencement selon l'une quelconque des revendications 1 ou 2,
**caractérisé en ce que**
les agencements d'anti-retour (12) sont conçus comme clapets anti-retour ou lamelles anti-retour.

4. Agencement selon l'une quelconque des revendications 1 à 3,
**caractérisé en ce qu'**
une densité, taille et/ou quantité de premières ouvertures (22) dans la cloison (20) augmentent en fonction de la distance de la position en tiroir (7) par rapport aux deuxièmes ouvertures (8) et/ou aux agencements d'anti-retour (12).

5. Agencement selon l'une quelconque des revendications 1 à 4,
**caractérisé en ce que**
l'unité d'évacuation d'air (3) comprend un échangeur de chaleur (26) destiné à transmettre l'énergie thermique de l'air échauffé à un fluide de refroidissement.

6. Agencement selon l'une quelconque des revendications 1 à 5,
**caractérisé en ce que**
les unités de ventilateur (3) sont conçues comme ventilateurs axial ou ventilateurs hélicoïde et **en ce que** l'unité d'évacuation d'air (3) est ouverte vers le haut dans la zone des unités de ventilateur (4).

7. Agencement selon l'une quelconque des revendications 1 à 6,
**caractérisé en ce que**
les au moins deux unités de ventilateur (4) sont disposées dans au moins deux dispositifs de maintien (18) séparés, lesquels peuvent être retirés individuellement hors de l'unité d'évacuation d'air (3).

8. Agencement selon l'une quelconque des revendications 1 à 7,
**caractérisé en ce que**
les unités de ventilateur (4) sont conçues comme composants hot plug amovibles pendant le fonctionnement, la deuxième ouverture (8a) associée, lors du retrait de respectivement une des unités de ventilateur (4a), étant automatiquement fermée par l'agencement d'anti-retour (12a) de sorte qu'une aspiration de l'air échauffé est réalisée par l'intermédiaire de l'autre unité de ventilateur (4b) respective.

9. Agencement selon l'une quelconque des revendications 1 à 8,
**caractérisé en ce que**
le dispositif de commande (16) est configuré pour comparer la pression mesurée par le premier capteur de pression (17) avec une valeur théorique et pour désactiver au moins une des au moins deux unités de ventilateur (4) lorsque seulement une unité de ventilateur (4) est nécessaire pour respecter la valeur théorique.

10. Agencement selon la revendication 9,
**caractérisé par**
au moins deux acteurs reliés au dispositif de commande (16) et assignés aux au moins deux agencements d'anti-retour (12), destinés à ouvrir et fermer les agencements d'anti-retour (12) au moyen du dispositif de commande (16).

11. Agencement selon l'une quelconque des revendications 1 à 10,
**caractérisé en ce que**
les agencements d'anti-retour (12) se ferment automatiquement lorsque dans le canal de dépression(11) il règne une pression d'air plus basse que dans la zone (13) de la deuxième ouverture (8) correspondante, et s'ouvrent automatiquement lorsque dans le canal de dépression(11) il règne une pression d'air plus élevée que dans la zone (13) de la deuxième ouverture (8) correspondante.

12. Agencement selon l'une quelconque des revendications 1 à 11,
**caractérisé en ce que**
l'unité d'évacuation d'air (3) est configurée pour le raccordement à un système d'évacuation d'air d'un bâtiment, notamment pour le raccordement à un canal de ventilation.

13. Boîtier en baie (1) destiné à loger une pluralité de composants en tiroir (15) pour l'utilisation dans un agencement selon l'une quelconque des revendications 1 à 12, comprenant :
- une pluralité de positions en tiroir (7) pour le logement de la pluralité de composants en tiroir (15) dans une première zone (5) du boîtier en baie (1), adjacente à un premier côté de boîtier,
- un canal de dépression (11) dans une deuxième zone (6) du boîtier en baie (1), adjacente à la première zone (5), et
- une cloison (20) disposée entre la première zone (5) et la deuxième zone (6), des premières ouvertures (22) étant disposées dans la cloison (20) entre le canal de dépression(11) et les composants en tiroir (15), lesquelles permettent l'évacuation dans le canal de dépression (11) de l'air échauffé par les composants en tiroir (15),
**caractérisé par**
- au moins deux deuxièmes ouvertures (8) du boîtier en baie (1), destinées à évacuer l'air échauffé hors du canal de dépression (11) afin d'établir la pression d'air baissée dans le canal de dépression (11),
- au moins deux agencements d'anti-retour (12) disposés dans le canal de dépression (11) et associés aux deux deuxièmes ouvertures (8) de manière à ce qu'ils empêchent une entrée d'air à travers la deuxième ouverture (8) respectivement associée, lorsque de l'air n'est pas aspiré à travers cette deuxième ouverture (8), et
- au moins une paroi de séparation (23) disposée entre les au moins deux agencements d'anti-retour (12) et au moins en partie dans le canal de dépression (11), destinée à augmenter une résistance d'écoulement entre les deux deuxièmes ouvertures (8), laquelle paroi de séparation sépare les unes des autres les deuxièmes ouvertures (8) du point de vue technique de l'écoulement de l'air, de sorte qu'en cas de défaillance d'un dispositif d'aspiration de l'air échauffé, il n'y ait pas de courant de court-circuit entre les deux deuxièmes ouvertures, et
- au moins un premier capteur de pression (17) dans la zone du canal de dépression (11), destiné à mesurer une pression dans le canal de dépression (11).
